# EUROPEAN PATENT SPECIFICATION

(11) **EP 3 648 286 B1**
(45) Date of publication and mention of the grant of the patent: **17.09.2025**
(21) Application number: 18203308.4
(22) Date of filing: 30.10.2018
(51) Int. Cl.: H02J 7/00, H02M 1/088

(54) **A BATTERY SYSTEM**
BATTERIESYSTEM
SYSTÈME DE BATTERIE

(43) Date of publication of application: 06.05.2020
(73) Proprietor: Samsung SDI Co., Ltd., Gyeonggi-do 17084 (KR)
(72) Inventor: Kurcik, Peter, 8505 St. Nikolai im Sausal (AT); Hofer, Maximilian, 8230 Hartberg (AT)
(74) Representative: Gulde & Partner

(56) References cited:
- EP-A1- 2 629 392
- US-A- 5 557 188
- US-A- 5 804 944

## Description

### Field of the Invention

The present invention relates to a battery system.

### Technological Background

In the recent years, vehicles for transportation of goods and peoples have been developed using electric power as a source for motion. Such an electric vehicle is an automobile that is propelled by an electric motor, using energy stored in rechargeable batteries. An electric vehicle may be solely powered by batteries or may be a form of hybrid vehicle powered by for example a gasoline generator. Furthermore, the vehicle may include a combination of electric motor and conventional combustion engine. In general, an electric-vehicle battery (EVB) or traction battery is a battery used to power the propulsion of battery electric vehicles (BEVs). Electric-vehicle batteries differ from starting, lighting, and ignition batteries because they are designed to give power over sustained periods of time. A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while high-capacity rechargeable batteries are used as the power supply for hybrid vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e.g. cylindrical or rectangular, depends on the battery's intended purpose. Lithium-ion (and similar lithium polymer) batteries, widely known via their use in laptops and consumer electronics, dominate the most recent group of electric vehicles in development.

Rechargeable batteries may be used as a battery module formed of a plurality of unit battery cells coupled in series and/or in parallel so as to provide a high energy density, in particular for motor driving of a hybrid vehicle. That is, the battery module is formed by interconnecting the electrode terminals of the plurality of unit battery cells depending on a required amount of power and in order to realize a high-power rechargeable battery.

A battery pack is a set of any number of (preferably identical) battery modules. They may be configured in a series, parallel or a mixture of both to deliver the desired voltage, capacity, or power density. Components of battery packs include the individual battery modules, and the interconnects, which provide electrical conductivity between them.

For meeting the dynamic power demands of various electrical consumers connected to the battery system a static control of battery power output and charging is not sufficient. Thus, steady exchange of information between the battery system and the controllers of the electrical consumers is required. This information includes the battery systems actual state of charge (SoC), potential electrical performance, charging ability and internal resistance as well as actual or predicted power demands or surpluses of the consumers.

Battery systems usually comprise a battery management system (BMS) and/or battery management unit (BMU) for processing the aforementioned information. The BMS/BMU may communicate to the controllers of the various electrical consumers via a suitable communication bus, e.g. a SPI or CAN interface. The BMS/BMU may further communicate with each of the battery submodules, particularly with a cell supervision circuit (CSC) of each battery submodule. The CSC may be further connected to a cell connection and sensing unit (CCU) of a battery submodule that interconnects the battery cells of the battery submodule.

Thus, the BMS/BMU is provided for managing the battery pack, such as by protecting the battery from operating outside its safe operating area, monitoring its state, calculating secondary data, reporting that data, controlling its environment, authenticating it and/or balancing it.

Relays are state of the art to be used separating cells from battery poles. OEMs are more and more requesting solutions based on MOSFET switches.

Exemplarily, the driver for a MOSFET switch in battery system is usually implemented on the PCB where the MOSFET is mounted. The driver for a BMS is usually implemented on the PCB where the BMS is mounted. However, such an arrangement would cause a cost increase because each of the MOSFET switch and the BMS is provided with an independent driver. In addition, each of the MOSFET switch and the BMS is provided with some other components and modules, which would also cause a cost increase.

US5557188A relates to an intelligent battery system for operating, for example, electronic devices, which battery system includes sufficient intelligence to control its charge rate, reduce discharge losses, and the ability to communicate with external systems.

### Summary of Invention

It is thus an object of the present invention to overcome or reduce at least some of the drawbacks of the prior art and to provide a battery system that comprises a solid state switch SSS and a battery management system BMS comprising at least one gate driver and a shunt, wherein the SSS and the BMS share the at least one gate driver and the shunt. The invention is set out in the appended set of claims.

The at least one of the gate driver and the shunt is used to drive the SSS.

The SSS may comprise at least one field-effect transistor FET, in particular a metal-oxide-semiconductor field-effect transistors (MOSFET).

The SSS may comprise at least one set of antiserially interconnected FETs, each set comprising a first FET and a second FET, wherein gate contacts of the FETs are electrically interconnected, source contacts of the FETs are electrically interconnected, first drain contact(s) of the first FET(s) is(are) electrically connected to a first terminal, and second drain contact(s) of the second FET(s) is(are) electrically connected to a second terminal, wherein the gate driver s connected with the SSS via a first driving line and a second driving line, the first driving line is connected with the gate contacts of the FETs, and the second driving line is connected with the source contacts of the FETs.

The gate contact of each FET may be electrically connected to the first driving line via a "gate" resistor, the source contact of each FET is electrically connected to the second driving line directly, and each FET have a "gate to source" resistor placed between the source contact and the gate contact thereof.

A resistor, a voltage suppression or zener diode and a capacitor may be connected in parallel between the first driving line and the second driving line, wherein the cathode of the diode is connected to the first driving line, and the anode of the diode is connected to the second driving line.

The gate driver and the shunt may be arranged in the BMS, wherein the gate driver is provided with pins Sense- and Sense+, and the two terminals of the shunt are connected to pins Sense- and Sense+ of the gate driver respectively.

A current measurement circuit comprising the shunt arranged in the BMS is shared by the SSS and the BMS.

The current measurement circuit comprises a first part connected to the shunt by SHUNT_PRI_ terminals and used for 1^{st} current measurement and a second part connected to the shunt by the SHUNT_SEC_ terminals and used for 2^{nd} current measurement, output of a first opamp of the second part is used to control the gate driver to drive the SSS.

A cascade of opamps may be arranged to provide a fast signal for the gate driver and provide at least one filter with a low corner frequency for the second part.

A cascade of opamps may further comprise at least one second opamp cascaded and connected to the output of the first opamp via terminal ISENSE_SEC and at least one filter is configured to be rearranged in a way that the at least one filter with the low corner frequency will not be realized by the first opamp but will be realized with the at least one second opamp in the cascade.

The at least one module may comprise a serial communication interface.

At least one of components and modules of a BMS are used by a SSS, thus the overall cost for a battery system can be reduced.

Further aspects of the present invention could be learned from the dependent claims or the following description.

### Brief Description of the Drawings

Features will become apparent to those of ordinary skill in the art by describing in detail exemplary embodiments with reference to the attached drawings in which:
Fig. 1 illustrates a schematic perspective view of a solid state switch according to an embodiment;
Fig. 2 illustrates a circuit for a solid state switch (SSS) (or a power stage) according to an embodiment;
Fig. 3 shows an exemplary block schematic of a switching system 3 according to an embodiment;
Fig. 4 shows an exemplary battery system comprising a power stage (or a solid state switch SSS) 31 and a battery management system (BMS) 4; and
Fig. 5 shows an exemplary circuit arrangement for current measurement.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. As used herein, the term "and/or" includes any and all combinations of one or more of the associated listed items. Further, the use of "may" when describing embodiments of the present invention refers to "one or more embodiments of the present invention."

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present invention.

In the following description of embodiments of the present invention, the terms of a singular form may include plural forms unless the context clearly indicates otherwise.

It will be further understood that the terms "include," "comprise," "including," or "comprising" specify a property, a region, a fixed number, a step, a process, an element, a component, and a combination thereof but do not exclude other properties, regions, fixed numbers, steps, processes, elements, components, and combinations thereof.

Features of the inventive concept and methods of accomplishing the same may be understood more readily by reference to the following detailed description of embodiments and the accompanying drawings. Hereinafter, example embodiments will be described in more detail with reference to the accompanying drawings, in which like reference numbers refer to like elements throughout. The present invention, however, may be embodied in various different forms, and should not be construed as being limited to only the illustrated embodiments herein. Rather, these embodiments are provided as examples so that this disclosure will be thorough and complete, and will fully convey the aspects and features of the present invention to those skilled in the art. Accordingly, processes, elements, and techniques that are not necessary to those having ordinary skill in the art for a complete understanding of the aspects and features of the present invention may not be described. Unless otherwise noted, like reference numerals denote like elements throughout the attached drawings and the written description, and thus, descriptions thereof will not be repeated. In the drawings, the relative sizes of elements, layers, and regions may be exaggerated for clarity.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present invention.

Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

It will be understood that when an element or layer is referred to as being "on," "connected to," or "coupled to" another element or layer, it can be directly on, connected to, or coupled to the other element or layer, or one or more intervening elements or layers may be present. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments only and is not intended to be limiting of the present invention. As used herein, the singular forms "a," "an," and "the" are intended to include the plural forms as well, unless the context clearly indicates otherwise. It will be further understood that the terms "comprises," "comprising," "includes," and "including," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Expressions such as "at least one of," when preceding a list of elements, modify the entire list of elements and do not modify the individual elements of the list.

As used herein, the term "substantially," "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of +/- 5% of the value centered on the value. Further, the use of "may" when describing embodiments of the present invention refers to "one or more embodiments of the present invention." Herein, the terms "upper" and "lower" are defined according to the z-axis. For example, the cover is positioned at the upper part of the z-axis, whereas the ground plate is positioned at the lower part thereof.

The electronic or electric devices and/or any other relevant devices or components according to embodiments of the present invention described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), or formed on one substrate. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the scope of the exemplary embodiments of the present invention.

Unless otherwise defined, all terms (including technical and scientific terms) used herein have the same meaning as commonly understood by one of ordinary skill in the art to which the present invention belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

A solid state switch (SSS), e.g. a solid state relay (SSR) or a solid state contactor (SSC), is a microelectronic device based on semiconductor technology. In contrast to conventional electro-mechanical switching technologies (i.e. conventional relays), solid state switches require no moving parts and allow absolutely quite operations. Due to their higher shock and vibration resistance they are ideal for application in harsh environments and allow ultrafast switching times (response to control signals in less that 100 µs). However, other kinds of SSS may also be used. For example, SSSs based on micro-electro-mechanical systems (MEMS) or micro-electro-opto-mechanical systems (MOEMS) can be used.

The SSS may comprise at least one field-effect transistor (FET). A FET is a microelectronic transistor that uses an electric field, which is applied between a gate contact and a source contact of the device, to control the electrical conductivity between the drain contact and the source contacts of the device. For a SSS, different kinds of FETs can be used. A FET may be a metal-oxide-semiconductor field-effect transistor (MOSFET). In particular, the FET may be a rear surface contact MOSFET, wherein the drain contact is located on the rear surface of the device and wherein the gate and the source contacts of the device are located on the top surface. All contact regions of the FET may be adapted to be electrically connected by physically contacting external contacts, by soldering, electrically conductive gluing, or by wiring (e.g. via wire bonds). A SSS may be defined by individual switching devices or switching elements (e.g. a FET) and the specific wiring scheme for connecting these devices.

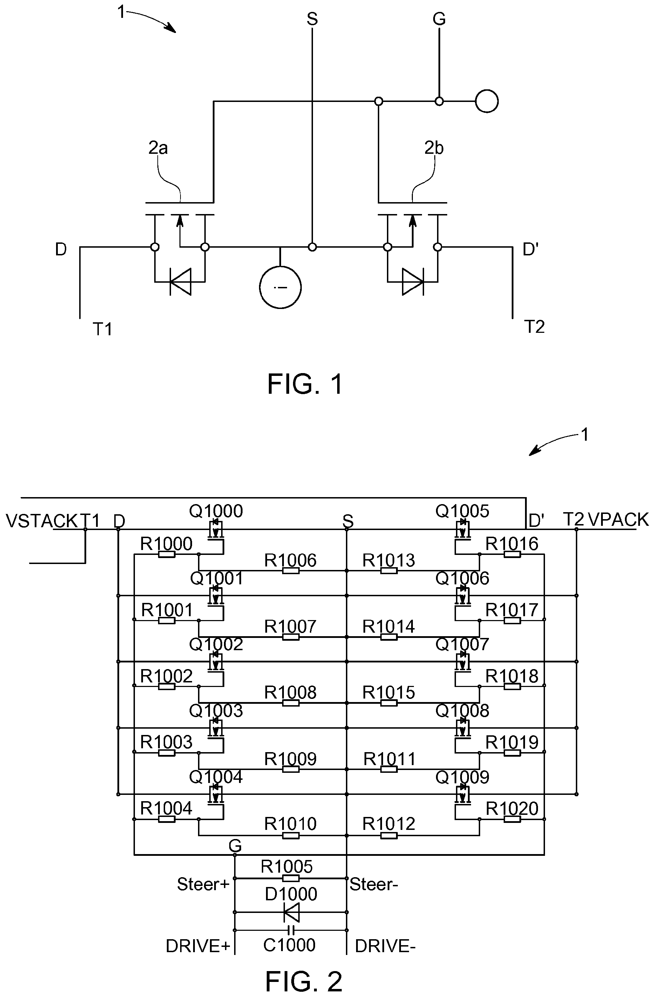

Fig. 1 illustrates an exemplary circuit for a solid state switch (SSS) according to an embodiment.

Referring to Fig. 1, the solid state switch (SSS) 1 comprises a first FET 2a and a second FET 2b which are antiserially interconnected, wherein gate contacts G of the FETs 2a, 2b are electrically interconnected, source contacts S of the FETs 2a, 2b are electrically interconnected, the drain contact D of the first FET 2a spaced apart from the drain contact D' of the second FET 2b.

In this embodiment, the solid state switch comprises a first FET 2a and a second FET 2b which are antiserially interconnected, wherein the gate contacts of the FETs are electrically interconnected, the source contacts of the FETs are electrically interconnected, the drain contact D of the first FET is electrically connected to the first terminal T1, and the drain contact D' of the second FET is electrically connected to the second terminal T2. In this configuration, both FETs can be controlled at once by applying a gate voltage to the gates of the FETs 2a, 2b.

In another embodiment, the solid state switch (SSS) 1 may comprise two or more sets of antiserially interconnected FETs, each set comprising a first FET and a second FET, wherein the gate contacts of the FETs are electrically interconnected, the source contacts of the FETs are electrically interconnected, the drain contacts of the first FETs are electrically connected to a first terminal T1, and the drain contacts of the second FETs are electrically connected to a second terminal T2. This configuration is a parallel connection of two or more solid state switches. Thus, the source contacts of the FETs are electrically interconnected, the gate contacts of the FETs are electrically interconnected, the drain contacts of the first FETs are electrically connected to the first terminal T1, and the drain contacts of the second FETs are electrically connected to the second terminal T2.

Fig. 2 illustrates a circuit for a solid state switch (SSS) (or a power stage) 1 according to an embodiment.

In the embodiment as shown in Fig. 2, the solid state switch (SSS) 1 comprises five sets of antiserially interconnected FETs, each set comprising a first FET and a second FET, wherein the gate contact of each FET is electrically connected to a first driving line DRIVE+ via a "gate" resistor R1000, R1001, R1002, R1003, R1004, R1016, R1017, R1018, R1019, R1020 (e.g., 10R value), the source contact of each FET is electrically connected to a second driving line DRIVE- directly, and each FET have a "gate to source" resistor R1006, R1007, R1008, R1009, R1010, R1011, R1012, R1013, R1015, R1015 (e.g., 10k value) placed between the source contact and the gate contact thereof, five drain contacts of the first FETs are electrically connected to the first terminal T1 (a terminal to V_{STACK}, V_{STACK} is the voltage at the positive end of the cell stack), and the five drain contacts of the second FETs are electrically connected to the second terminal T2 (a terminal to V_{PACK}, V_{PACK} is the voltage at positive output terminal of the battery pack). According to this embodiment, gate resistors (e.g., R1000-R1004 and R1016-R1020) have the purpose of limiting the gate current when the FETs are turned ON and OFF, exact value of the gate resistors depends on the gate driver design, and gate to source resistors (e.g., R1006-R1015) have the purpose of turning off the FETs in case the driving lines are floating for example because of a circuit failure.

As also shown in Fig. 2, a resistor R1005 (e.g., 10k value), a diode D1000 (e.g., 16V) and a capacitor C1000 (e.g., 100n) are connected in parallel between the first driving line Drive+ and the second driving line Drive-. The cathode of the diode D1000 is connected to the first driving line Drive+, and the anode of the diode D1000 is connected to the second driving line Drive-. The circuit comprising the resistor R1005, the diode D1000 and the capacitor C1000 may be a part of a gate driver. The components in the circuit have following functions: the resistor R1005 (e.g., 10k) has the same function as the gate to source resistors (R1006-1015) placed between the gates and sources of the FETs and can be used if more redundancy regarding resistor is required. However, if more redundancy regarding resistor is not required, the resistor R1005 (e.g., 10k) can be used to perform the same function as each gate to source resistor placed at each FET, and thus some or all of the gate to source resistors (R1006-1015) can be omitted. Value of the resistors is an example. In fact, the resistor can have different values, but preferably within 10kOhm range. The diode D1000 can be either Zener diode or TVS (transient voltage suppressor) and its function is to keep the gate-source voltages of the FETs below 20V (which can differ based on the FETs used, but 20V is a preferred maximum gate-source voltage). The diode can protect the FETs from voltage spikes for example an electrostatic discharge ESD pulses if it is fast enough. The function of the capacitor C1000 is to absorb the energy of the ESD pulses, and together with the diode D1000 (e.g., 16V), to ensure that the power stage will be not destroyed by ESD pulses. Thus, the diode D1000 and the capacitor C1000 can be considered as ESD protection components. The ESD protection components are necessary especially when the power stage is physically separated from the gate driver, e.g., they are interconnected with cable or other connectors) and those components are arranged close to the solid state switch (SSS) 1.

For a MOSFET switch, a driver with OCP (over current protection) may be needed. The OCP may be realized by measuring V_{DS} at the MOSFET or a separate shunt in the power stage in series with the MOSFETs. By measuring the V_{DS}, it was meant to measure the voltage drop between the drain and source of the FET, or parallel combination of more FETs. When the "on" state resistance of FET is known, current passing through the FET can be calculated from this voltage drop. A shunt, also referred to as current sense resistor, shunt resistor or obsolete as shunt resistance, is a low-resistance electrical measuring resistor, which is used to measure the electrical current. The current flowing through a shunt causes a voltage drop proportional to its magnitude which is measured.

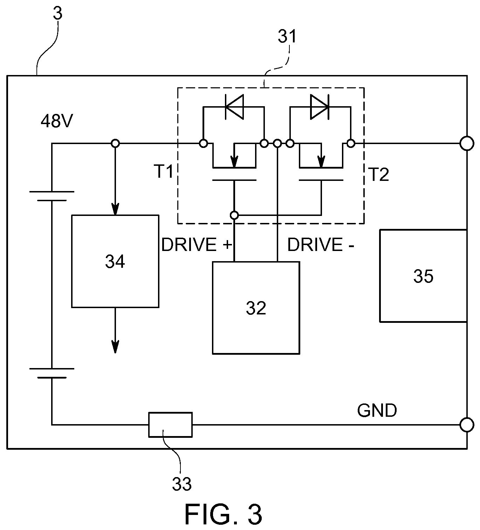

Fig. 3 shows an exemplary block schematic of a switching system 3. The switching system 3 comprises at least the solid state switch 31 and a gate driver 32. The switching system 3 may further include some additional functionality like over current protection, a serial communication interface, etc.

In the switching system 3 of Fig. 3, in addition to the solid state switch (SSS) 31 comprising a first FET and a second FET, a separate shunt 33 is provided in series with the FETs. The shunt 33 is used to measure the electrical current flowing through the first and second FETs of the solid state switch (SSS) 31. The FETs may be MOSFETs. The gate server 32 may be provided to drive the solid state switch (SSS) 31. The first driving line DRIVE+ from the gate driver 32 is connected with the gate contacts of the first FET and the second FET, and the second driving line DRIVE- from the gate driver 32 is connected with the source contacts of the first FET and the second FET.

The switching system 3 may further comprise a power source (e.g., 48V), a DC/DC converter 34 connected with the first terminal T1, a shunt 33 connected between the negative terminal of the power source and GND, a CAN interface 35 connected between the second terminal T2 and a first terminal of the shunt 33 connected to GND. A second terminal of the shunt 33 is connected to the negative terminal of the power source and the positive terminal of the power source is connected with the first terminal T1 and the DC/DC converter 34. A DC-to-DC converter is an electronic circuit or electromechanical device that converts a source of direct current (DC) from one voltage level to another. It is a type of electric power converter. Power levels range from very low (small batteries) to very high (high-voltage power transmission). The switching system 3 which includes a solid state switch (SSS) 31 and a gate server 32, and optionally some other components or modules, can be provided independently or share some modules with a BMS. Although Fig. 3 shows a standalone switching system, some of the modules can be shared with a BMS if there is already this functionality in the BMS. Examples of reusable blocks are the current measurement circuit used by an overcurrent protection module and serial communication interfaces.

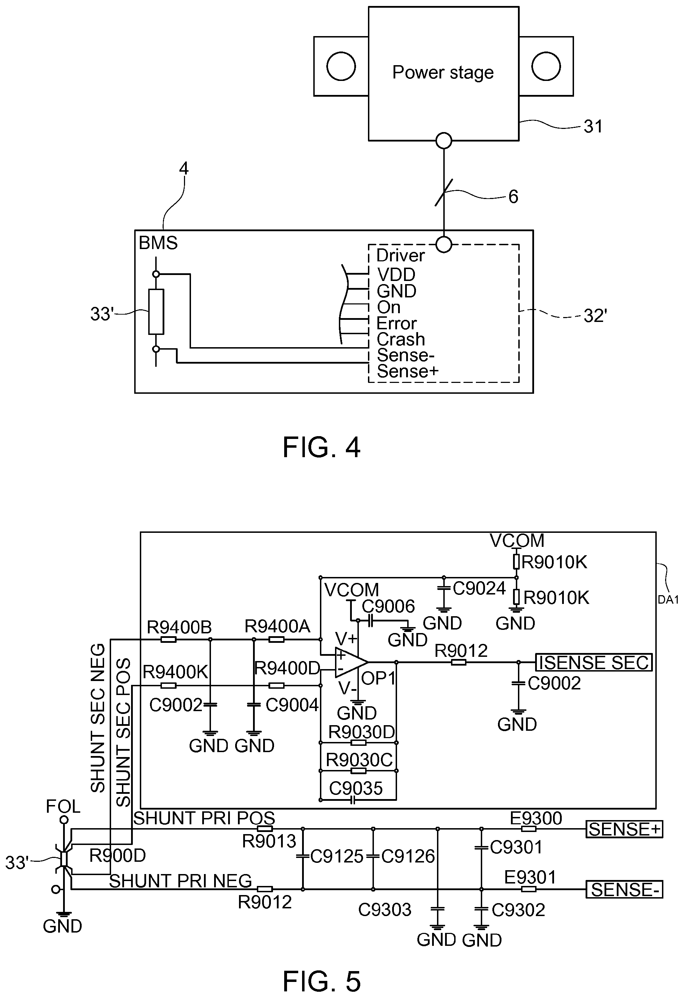

Fig. 4 shows an exemplary battery system comprising a power stage (or a solid state switch (SSS)) 31 and a battery management system (BMS) 4. A battery management system (BMS) is any electronic system that manages a rechargeable battery (cell or battery pack), such as by protecting the battery from operating outside its Safe Operating Area, monitoring its state, calculating secondary data, reporting that data, controlling its environment, authenticating it and/or balancing it.

As shown in Fig. 4, the battery management system (BMS) 4 may comprise a shunt 33' and a driver 32'. Exemplarily, the driver 32'of the battery management system (BMS) 4 is provided with pins VDD, GND, On, Error, Crash, Sense- and Sense+, and the two terminals of the shunt 33' are connected to pins Sense- and Sense+ of the driver respectively. The pins for the driver 32' of the BMS 4 are not limited to those shown in Fig. 4, but can comprise less or more pins depending on the actual needs.

Referring to Figs 3 and 4, since each of a switching system 3 and a BMS 4 may comprise a shunt and a driver among modules used for a power stage (or a solid state switch (SSS)) 31, thus if the driver and/or the shunt can be shared by the solid state switch (SSS) 31 and the BMS 4, then it can save some cost. Fig. 4 generally shows that the driver 32' of the BMS is connected with the power stage (or a solid state switch SSS) 31 via a connection 6 for the solid state switch SSS 31 to use.

Fig. 5 shows an exemplary circuit arrangement for current measurement. The circuit as shown in Fig. 5 is a circuit used in one of BMS designs, which comprises two parts.

The first part (the lower part) of the circuit, connected to the shunt 33' by the SHUNT_PRI_ terminals is the so called primary channel used for 1^{nd} current measurement, which may be fed into an application specific integrated circuit (ASIC) which provides rest of the functions for very accurate current measurement. Two terminals of the shunt 33' of the BMS 4 are connected to pins Sense+ and Sense- of the driver 32' of the BMS respectively via a circuit comprising some resistors and capacitors.

The second part (the upper part) of the circuit, connected to the shunt 33' by the SHUNT_SEC_ terminals is the so called secondary channel used for 2^{nd} current measurement, which provides redundant current measurement capability for safety reasons. The second part includes a differential amplifier DA1 that comprises an opamp OP1 and resistors. Output of the differential amplifier DA1 of the secondary channel is then measured by ordinary analog to digital converter.

The signal from the shunt 33' after being processed in the primary channel may also be fed into the secondary channel. In the secondary channel, the signal is preamplified, compared with desired current threshold and then may be used to control the gate driver. In particular, the magnitude of voltage measured on the shunt 33' is in the microvolt range, thus it needs a pre-processing so as to be used by other circuits. For example, to use the signal from the shunt 33' for over current protection, the signal needs to be amplified first (for example by an differential amplifier DA1 in the secondary channel of Fig. 6, which is) and then a voltage signal already in the millivolt or volt range is got, and the voltage signal is proportional to the current passing through the shunt 33'. Then this voltage signal can be compared with a predefined overcurrent threshold by the differential amplifier DA1. The output of the differential amplifier DA1 can be used to control the gate driver 32, 32' to drive the solid state switch is SSS 31. In particular, in case the voltage is greater than the threshold, the gate driver is turned off, then the solid state switch is SSS 31 is turned off and in the end the input and the output of the switching system 3 became disconnected. Otherwise, in case the voltage is not greater than the threshold, the gate driver 32, 32' remains turned on, then the solid state switch SSS 31remains turned on and the input and the output of the switching system 3 remains connected.

In addition, for driving both the BMS and the SSS, e.g., the Shunt and/or the preamplifier DA1 from the secondary channel can also be used for the driver of the solid state switch SSS, filters may be adapted. For the driver of the solid state switch SSS, a fast signal is provided, while for the secondary channel of the circuit of the BMS, a filter with a low corner frequency is provided. This is solved by a cascade of opamps. The cascade of the opamps is used to convert the signals with different input gains without a Programmable Gain Amplifier (PGA).

Opamp circuits have the advantage that they can be cascaded without changing their input-output relationships. This is due to the fact that each (ideal) opamp circuit has infinite input resistance and zero output resistance.

According to an exemplary embodiment, a cascaded connection of the opamps with three-stage is provided.

Cascade of the opamps according to said embodiment is arranged to provide a fast signal for the gate driver and provide at least one filter with a low corner frequency for the 2nd current measurement.

In particular, at least one second opamp may be cascaded and connected to the output of the first opamp (the existing differential opamp) via the terminal ISENSE_SEC and at least one filter can be rearranged in a way that the at least one filter with the low corner frequency will not be realized by the first opamp (differential amplifier DA1) but will be realized with the at least one second opamp in the cascade. The first opamp (differential amplifier DA1) will only be a filter with high corner frequency to suppress high frequency noise. Signal after the at least one second opamp will have very similar properties as the signal from the ISENSE_SEC of the circuit. In this way, strongly filtered signal for the secondary channel and also lightly filtered (fast) signal for the comparator of the overcurrent protection circuit, can be obtained. Additionally to rearrangement of the at least one filter, the gains of the opamps in the cascade can be rearranged to be optimally suited for the application. For example, the circuit may have gain of 50, but in the cascade arrangement, the gain can be split between the two opamps, for example the first opamp can have a gain of 10 and the second opamp can have a gain of 5.

The above embodiments describe that a driver and/or a shunt of a BMS may be used by a SSS, but the present invention is not limited to such embodiments. The person skilled in the art would understand that other components and modules in a BMS, which can also be used for a SSS, can be used by the SSS. The components and modules may further comprise the current measurement circuit used for overcurrent protection and serial communication interfaces, Exemplarily, a power source, a CAN interface, a current measurement circuit comprising a shunt in a BMS can also be used by a SSS. In a word, as long as at least one of components and modules of a BMS are used by a SSS, the overall cost for a battery system can be reduced.

## Claims

1. A battery system comprising:
a solid state switch SSS (31), and
a battery management system BMS (4),
**characterized in that** the BMS (4) comprises a shunt (33') and a current measurement circuit,
wherein the SSS (31) and the BMS (4) share modules that can be used for both the SSS (31) and the BMS (4),
wherein the modules comprise the shunt (33') and the current measurement circuit,
wherein the current measurement circuit comprises a first part connected to the shunt (33') via a primary channel and a second part connected to the shunt (33') via a secondary channel,
the first part is used for a 1^{st} current measurement, and
the second part is used for a 2^{nd} current measurement, which provides redundant current measurement for safety reasons and is further configured to control a gate driver (32, 32') to drive the SSS (31),
wherein a cascade of opamps is arranged in the second part to convert signals with different input gains without a Programmable Gain Amplifier, PGA, and is arranged to provide a fast signal for the gate driver (32, 32') to drive the SSS (31) and provide at least one filter with a low corner frequency for the BMS.

2. The battery system according to claim 1, wherein the SSS (31) comprises at least one field-effect transistor FET.

3. The battery system according to claim 2, wherein the SSS (31) comprises at least one set of antiserially interconnected FETs, each set comprising a first FET and a second FET, wherein gate contacts of the FETs are electrically interconnected, source contacts of the FETs are electrically interconnected, first drain contact(s) (D) of the first FET(s) is(are) electrically connected to a first terminal (T1), and second drain contact(s) (D') of the second FET(s) is(are) electrically connected to a second terminal (T2),
wherein the gate driver (32, 32') is connected with the SSS (31) via a first driving line (Drive+) and a second driving line (Drive-), the first driving line (Drive+) is connected with the gate contacts of the FETs, and the second driving line (Drive-) is connected with the source contacts of the FETs.

4. The battery system according to claim 2 or 3, wherein the gate contact of each FET is electrically connected to the first driving line (Drive+) via a "gate" resistor, the source contact of each FET is electrically connected to the second driving line (DRIVE-) directly, and each FET have a "gate to source" resistor placed between the source contact and the gate contact thereof.

5. The battery system according to any of claim 3 or 4, wherein a resistor (R1005), a diode (D1000) and a capacitor (C1000) are connected in parallel between the first driving line (Drive+) and the second driving line (Drive-), wherein the cathode of the diode (D1000) is connected to the first driving line (Drive+), and the anode of the diode (D1000) is connected to the second driving line (Drive-).

6. The battery system according to any of claims 1 to 5, wherein the gate driver (32') and the shunt (33') are arranged in the BMS (4).

7. The battery system according to any of claims 1 to 6, wherein the current measurement circuit comprising the shunt (33') is arranged in the BMS (4).

8. The battery system according to claim 7, wherein the second part comprises a first opamp which is used to control the gate driver (32, 32') to drive the SSS (31).

9. The battery system according to claim 1, wherein the cascade of opamps further comprises at least one second opamp cascaded and connected to the output of the first opamp via terminal ISENSE_SEC and at least one filter is configured to be rearranged in a way that the at least one filter with the low corner frequency will not be realized by the first opamp but will be realized with the at least one second opamp in the cascade.

10. The battery system according to any of claims 1 to 9, wherein the modules further comprise a serial communication interface.

11. The battery system according to claim 8, wherein the second part comprises a differential amplifier (DA1) for comparing a voltage signal corresponding to a current through the shunt (33') with an overcurrent threshold for controlling the gate driver (32, 32').

## Patentansprüche

1. Batteriesystem, umfassend:
einen Festkörperschalter, *solid state switch* - SSS, (31) und
ein Batteriemanagementsystem, *battery management system -* BMS (4),
**dadurch gekennzeichnet, dass** das BMS (4) einen Shunt (33') und eine Strommessschaltung umfasst,
wobei der SSS (31) und das BMS (4) Module gemeinsam nutzen, die sowohl für den SSS (31) als auch für das BMS (4) verwendet werden können,
wobei die Module den Shunt (33') und die Strommessschaltung umfassen,
wobei die Strommessschaltung einen ersten Teil, der über einen Primärkanal mit dem Shunt (33') verbunden ist, und einen zweiten Teil, der über einen Sekundärkanal mit dem Shunt (33') verbunden ist, umfasst,
der erste Teil für eine 1. Strommessung verwendet wird und
der zweite Teil für eine 2. Strommessung verwendet wird, die aus Sicherheitsgründen eine redundante Strommessung bereitstellt und ferner dazu ausgestaltet ist, einen Gate-Treiber (32, 32') zu steuern, um den SSS (31) anzutreiben,
wobei im zweiten Teil eine Kaskade von Operationsverstärkern angeordnet ist, um Signale mit unterschiedlichen Eingangsverstärkungen ohne einen programmierbaren Verstärker (*Programmable Gain Amplifier -* PGA) umzuwandeln, und die angeordnet ist, um ein schnelles Signal für den Gate-Treiber (32, 32') zum Antreiben des SSS (31) bereitzustellen und wenigstens ein Filter mit einer niedrigen Eckfrequenz für das BMS bereitzustellen.

2. Batteriesystem nach Anspruch 1, wobei der SSS (31) wenigstens einen Feldeffekttransistor, *field-effect transistor -* FET, umfasst.

3. Batteriesystem nach Anspruch 2, wobei der SSS (31) wenigstens einen Satz von antiparallel geschalteten FETs umfasst, wobei jeder Satz einen ersten FET und einen zweiten FET umfasst, wobei Gate-Kontakte der FETs elektrisch miteinander verbunden sind, Source-Kontakte der FETs elektrisch miteinander verbunden sind, erste Drain-Kontakte(D) des ersten FETs (der ersten FETs) elektrisch mit einem ersten Anschluss (T1) verbunden ist (sind) und der (die) zweite(n) Drain-Kontakt(e) (D') des zweiten FETs (der zweiten FETs) elektrisch mit einem zweiten Anschluss (T2) verbunden ist (sind),
wobei der Gate-Treiber (32, 32') über eine erste Treiberleitung (Drive+) und eine zweite Treiberleitung (Drive-) mit dem SSS (31) verbunden ist, wobei die erste Treiberleitung (Drive+) mit den Gate-Kontakten der FETs verbunden ist und die zweite Treiberleitung (Drive-) mit den Source-Kontakten der FETs verbunden ist.

4. Batteriesystem nach Anspruch 2 oder 3, wobei der Gate-Kontakt jedes FET über einen "Gate"-Widerstand elektrisch mit der ersten Treiberleitung (Drive+) verbunden ist, der Source-Kontakt jedes FET direkt mit der zweiten Treiberleitung (DRIVE-) elektrisch verbunden ist und jeder FET einen "Gate-to-Source"-Widerstand aufweist, der zwischen dem Source-Kontakt und dem Gate-Kontakt desselben angeordnet ist.

5. Batteriesystem nach einem der Ansprüche 3 oder 4, wobei ein Widerstand (R1005), eine Diode (D1000) und ein Kondensator (C1000) parallel zwischen der ersten Treiberleitung (Drive+) und der zweiten Treiberleitung (Drive-) geschaltet sind, wobei die Kathode der Diode (D1000) mit der ersten Treiberleitung (Drive+) verbunden ist und die Anode der Diode (D1000) mit der zweiten Treiberleitung (Drive-) verbunden ist.

6. Batteriesystem nach einem der Ansprüche 1 bis 5, wobei der Gate-Treiber (32') und der Shunt (33') in dem BMS (4) angeordnet sind.

7. Batteriesystem nach einem der Ansprüche 1 bis 6, wobei die Strommessschaltung, die den Shunt (33') umfasst, in dem BMS (4) angeordnet ist.

8. Batteriesystem nach Anspruch 7, wobei der zweite Teil einen ersten Operationsverstärker umfasst, der dazu verwendet wird, den Gate-Treiber (32, 32') zum Antreiben des SSS (31) zu steuern.

9. Batteriesystem nach Anspruch 1, wobei die Kaskade von Operationsverstärkern ferner wenigstens einen zweiten Operationsverstärker umfasst, der kaskadiert und über den Anschluss ISENSE_SEC mit dem Ausgang des ersten Operationsverstärkers verbunden ist, und wenigstens ein Filter dazu ausgestaltet ist, so umgeordnet zu werden, dass das wenigstens eine Filter mit der niedrigen Eckfrequenz nicht durch den ersten Operationsverstärker realisiert wird, sondern durch den wenigstens einen zweiten Operationsverstärker in der Kaskade realisiert wird.

10. Batteriesystem nach einem der Ansprüche 1 bis 9, wobei die Module ferner eine serielle Kommunikationsschnittstelle umfassen.

11. Batteriesystem nach Anspruch 8, wobei der zweite Teil einen Differenzverstärker (*differential amplifier -* DA1) zum Vergleichen eines einem Strom durch den Shunt (33') entsprechenden Spannungssignals mit einer Überstromschwelle zum Steuern des Gate-Treibers (32, 32') umfasst.

## Revendications

1. Système de batterie comportant :
un commutateur à semi-conducteurs SSS (31), et
un système de gestion de batterie BMS (4),
**caractérisé en ce que** le BMS (4) comporte un shunt (33') et un circuit de mesure de courant,
dans lequel le SSS (31) et le BMS (4) partagent des modules qui peuvent être utilisés à la fois pour le SSS (31) et le BMS (4),
dans lequel les modules comportent le shunt (33') et le circuit de mesure de courant,
dans lequel le circuit de mesure de courant comporte une première partie connectée au shunt (33') via un canal primaire et une deuxième partie connectée au shunt (33') via un canal secondaire,
la première partie est utilisée pour une 1^{re} mesure de courant, et
la deuxième partie est utilisée pour une 2^{e} mesure de courant, qui fournit une mesure de courant redondante pour des raisons de sécurité et est en outre configurée pour contrôler un circuit de commande de grille (32, 32') afin de commander le SSS (31),
dans lequel une cascade d'amplificateurs opérationnels est agencée dans la deuxième partie pour convertir des signaux avec des gains d'entrée différents sans un amplificateur à gain programmable, PGA, et est agencée pour fournir un signal rapide pour le circuit de commande de grille (32, 32') afin de commander le SSS (31) et fournir au moins un filtre avec une fréquence de coude basse pour le BMS.

2. Système de batterie selon la revendication 1, dans lequel le SSS (31) comporte au moins un transistor à effet de champ FET.

3. Système de batterie selon la revendication 2, dans lequel le SSS (31) comporte au moins un ensemble de FET interconnectés en antisérie, chaque ensemble comportant un premier FET et un deuxième FET, dans lequel des contacts de grille des FET sont interconnectés électriquement, des contacts de source des FET sont interconnectés électriquement, un ou plusieurs premiers contacts de drain (D) du ou des premiers FET sont connectés électriquement à une première borne (T1), et un ou plusieurs deuxièmes contacts de drain (D') du ou des deuxièmes FET sont connectés électriquement à une deuxième borne (T2),
dans lequel le circuit de commande de grille (32, 32') est connecté au SSS (31) via une première ligne de commande (Drive+) et une deuxième ligne de commande (Drive-), la première ligne de commande (Drive+) est connectée aux contacts de grille des FET, et la deuxième ligne de commande (Drive-) est connectée aux contacts de source des FET.

4. Système de batterie selon la revendication 2 ou 3, dans lequel le contact de grille de chaque FET est connecté électriquement à la première ligne de commande (Drive+) via une résistance de « grille », le contact de source de chaque FET est connecté électriquement à la deuxième ligne de commande (Drive-) directement, et chaque FET présente une résistance « grille-source » placée entre le contact de source et le contact de grille de celui-ci.

5. Système de batterie selon l'une quelconque des revendications 3 ou 4, dans lequel une résistance (R1005), une diode (D1000) et un condensateur (C1000) sont connectés en parallèle entre la première ligne de commande (Drive+) et la deuxième ligne de commande (Drive-), dans lequel la cathode de la diode (D1000) est connectée à la première ligne de commande (Drive+), et l'anode de la diode (D1000) est connectée à la deuxième ligne de commande (Drive-).

6. Système de batterie selon l'une quelconque des revendications 1 à 5, dans lequel le circuit de commande de grille (32') et le shunt (33') sont agencés dans le BMS (4).

7. Système de batterie selon l'une quelconque des revendications 1 à 6, dans lequel le circuit de mesure de courant comportant le shunt (33') est agencé dans le BMS (4).

8. Système de batterie selon la revendication 7, dans lequel la deuxième partie comporte un premier amplificateur opérationnel qui est utilisé pour contrôler le circuit de commande de grille (32, 32') afin de commander le SSS (31).

9. Système de batterie selon la revendication 1, dans lequel la cascade d'amplificateurs opérationnels comporte en outre au moins un deuxième amplificateur opérationnel mis en cascade et connecté à la sortie du premier amplificateur opérationnel via une borne ISENSE_SEC et au moins un filtre est configuré pour être réarrangé d'une manière telle que l'au moins un filtre avec la fréquence de coude basse ne soit pas réalisé avec le premier amplificateur opérationnel mais soit réalisé avec l'au moins un deuxième amplificateur opérationnel dans la cascade.

10. Système de batterie selon l'une quelconque des revendications 1 à 9, dans lequel les modules comportent en outre une interface de communication série.

11. Système de batterie selon la revendication 8, dans lequel la deuxième partie comporte un amplificateur différentiel (DA1) pour comparer un signal de tension correspondant à un courant traversant le shunt (33') à un seuil de surintensité pour contrôler le circuit de commande de grille (32, 32').
